Europäisches Patentamt

**European Patent Office**

**Office européen des brevets**

(11) Publication number: **0 157 685**
A1

# EUROPEAN PATENT APPLICATION

(21) Application number: **85400500.6**

(22) Date of filing: **15.03.85**

(51) Int. Cl.⁴: **H 01 L 23/48, H 01 L 23/10**

(30) Priority: **20.03.84 US 591471**

(43) Date of publication of application: **09.10.85**
**Bulletin 85/41**

(84) Designated Contracting States: **DE FR GB**

(71) Applicant: **ISOTRONICS, INC., Industrial Park, New Bedford Massachusetts 02745 (US)**

(72) Inventor: **Tower, Steven A., 13 Onyx Drive, No. Dartmouth Massachusetts 02747 (US)**

(74) Representative: **Descourtieux, Philippe et al, CABINET BEAU de LOMENIE 55 rue d'Amsterdam, F-75008 Paris (FR)**

(54) Corrosion resistant microcircuit package.

(57) A microcircuit package utilizes a two-part bimetal lead frame (10) to achieve high-integrity matched hermetic seals for withstanding corrosion including salt spray through the utilization of a two-part lead comprising in one embodiment a "Kovar" portion (12) which passes from the interior of the package through the glass seal (30) to within a predetermined short distance of the package exterior. At this point the "Kovar" lead portion (12) is mechanically and electrically connected to another metal lead frame portion (14) which passes the rest of the way through the glass seal (30) and extends from the microcircuit package, with the exteriorly extending lead frame portion (14) being selected for either corrosion resistance or improved thermal or electrical characteristics, or both.

FIELD OF INVENTION

This invention relates to microcircuit packaging techniques and more particularly to a corrosion resistant microcircuit package for use in high reliability applications.

BACKGROUND OF THE INVENTION

Formerly, matched hermetic seals and microcircuit packages have utilized a ring made of an alloy known under the name of "Kovar" (an F-15 alloy containing nickel, iron, and cobalt) which serves as a frame. A base of "Kovar" is sealed to the frame, with "Kovar" leads extending from the exterior of the frame to the interior of the package through side wall apertures filled with borosilicate glass feedthroughs having the same thermal coefficient of expansion as the "Kovar". Most such packages are plated with a corrosion resistant layer of nickel followed by gold for wire bonding to the leads. However, in the fabrication and assembly of such packages, as well as in handling after plating, minor cracks are created in the meniscus between the "Kovar" lead and the glass feedthrough. Moreover, chip-outs occur leaving areas no longer covered by the glass. These areas are open to corrosive attack from salt spray and create failures by exhibiting discoloration and rust. These problems are particularly severe in aeronautical applications as well as in naval applications in which salt spray and corrosion problems are pervasive.

By way of further background, integrated circuit packaging has developed to the point that integrated circuits or microcircuits may be hermetically sealed into a package called a "flat pack" which comprises a base secured to a rectangular ring, with the microcircuit located on the base within the ring. The sides of the ring are provided with glass feedthroughs which are utilized to insulate and seal the lead passing therethrough to the interior of the ring. In some instances, the interior ends of the leads form contact pads which are bonded to corresponding pads on the microcircuit so that electrical connection can be made to and from the microcircuit. In other instances, conventional wire bonding is utilized.

In general, for such flat packs a 40-mil (.04 inch or 1 mm) wall thickness of the ring is utilized when the packages are closed by welding on a lid or cover. Welding is desirable because it is inexpensive and because the hermeticity achievable with welded lids far exceeds that of solder-based systems. Additionally, processing yields utilizing welding are considerably higher than the yields associated with soldering. Depending on the application, nonweldable packages utilize lids soldered to respective rings. In order to achieve hermetic seals with standard processing techniques, both the package and the lid are usually flash-coated with gold, and glass feedthroughs are used for the package leads.

U.S. Patent Nos. 2,880,383 ; 3,190,952 ; 3,340,602 ; 3,349,481 ; 3,374,537 ; 3,404,213 ; 3,408,451 ; 3,423,639 ; 3,435,516 ; 3,538,587 ; 3,546,543 ; 3,548,076 ; 3,619,734 ; 3,644,798 ; 3,648,357 ; 3,663,868 ; 3,669,715 ; 3,676,569 ; 3,697,666 ; 3,726,006 ; 3,733,691 ; 3,753,054 ; 3,768,144 ; 3,774,232 ; 3,823,468 ; 3,848,077 ; 3,874,549 ; 3,896,542 ; 3,945,557 ; 3,988,825 ; 4,063,348 ; 4,135,038 ; 4,149,910 ; 4,192,433 ; 4,227,036 ; 4,262,300 ; 4,266,089 ; 4,266,090 ; 4,331,253 ; and 4,331,258 all illustrate methods and apparatus for sealing flat packs.

In addition to the above-noted patents, U.S. Patent Application Serial No. 557,640, filed December 2, 1983, assigned to the applicant hereof, illustrates a method and apparatus for reducing package height for microcircuit packages which illustrates a typical flat pack configuration. Moreover, U.S. Patent Application Serial No. 457,112, filed January 10, 1983, assigned to the applicant hereof, illustrates a microwave chip carrier with subminiature ceramic feedthroughs. Also, U.S. Patent Application No. 413,169 filed August 30, 1982 assigned to the applicant hereof illustrates a "Kovar", "Thermicon" flat pack structure.

In all of the above-mentioned flat packs, the leads are one-piece or continuous from the interior of the flat pack to the exterior.

## SUMMARY OF THE INVENTION

In the subject invention, rather than having a one-piece continuous lead of the same metal from the interior of the flat pack to the exterior of the flat pack, the subject invention utilizes a two-part bimetal lead in which the interior portion is made of one electrically conductive material and is mechanically and electrically secured to another portion which extends exteriorly of the package. This exteriorly extending portion of the lead is made from an electrically conductive corrosion resistant material or one having improved thermal or electrical performance characteristics, or both. The interior portion of the lead is made of an electrical conductor which bonds well to the feedthrough material, usually glass, and which has a thermal coefficient of expansion which matches the feedthrough material. The joint between the interior portion of the lead, and the exterior portion of the lead is spaced from the exterior of the package by as little as possible such that the majority of the feedthrough surrounding the lead bonds effectively to the interior lead portion, in one embodiment, "Kovar". In certain instances it may be necessary to increase the thickness of the ring frame by ten thousandths of an inch, in one embodiment, so as to increase the length of the effective high reliability seal between the feedthrough material and the interior lead portion.

While the subject invention will be described in terms of "Kovar" and corrosion resistant metals such as nickel, stainless steel or aluminum, etc., this invention is not limited thereby, but is rather directed to the utilization of a multipart lead of differing electrically conductive materials which has a joint or joints within the seal utilized in the flat pack side wall.

In summary, a microcircuit package utilizes a two or more part lead frame to achieve high integrity matched hermetic seals to withstand environmental testing for corrosion resistance including salt spray through the utilization in one embodiment of a two-part lead comprising a "Kovar" portion which passes from the interior of the package through the glass seal to within a predetermined short distance from the exterior package surface. At this point the "Kovar" lead is welded to a corrosion resistant metal lead which passes the rest of the way through the glass seal and extends from the microcircuit passage, with the corrosion resistant metal being picked for either corrosion resistance performance or improved thermal or electrical characteristics or both.

BRIEF DESCRIPTION OF THE DRAWINGS

These and other features of the subject invention will be better understood in connection with the detailed description taken in conjunction with the drawings in which :

Fig. 1 is a diagrammatical representation of a multi-part lead frame for use in a flat pack microcircuit package ;

Fig. 2 is a diagrammatic illustration of the utilization of the lead frame of Fig. 1 in a flat pack configuration in which the multi-part lead frame leads pass through side walls of the ring of the flat pack ;

Fig. 3 is a diagrammatic and sectional view of a portion of the microcircuit package of Fig. 2 illustrating the joint between the two parts of the lead frame ; and

Fig. 4 is a cross-sectional view of a portion of the flat pack of Fig. 2 illustrating the portion of the flat pack feedthrough which contains the multi-part lead frame, also illustrating the relative lengths of the two parts of the lead frame within the feedthrough.

DETAILED DESCRIPTION

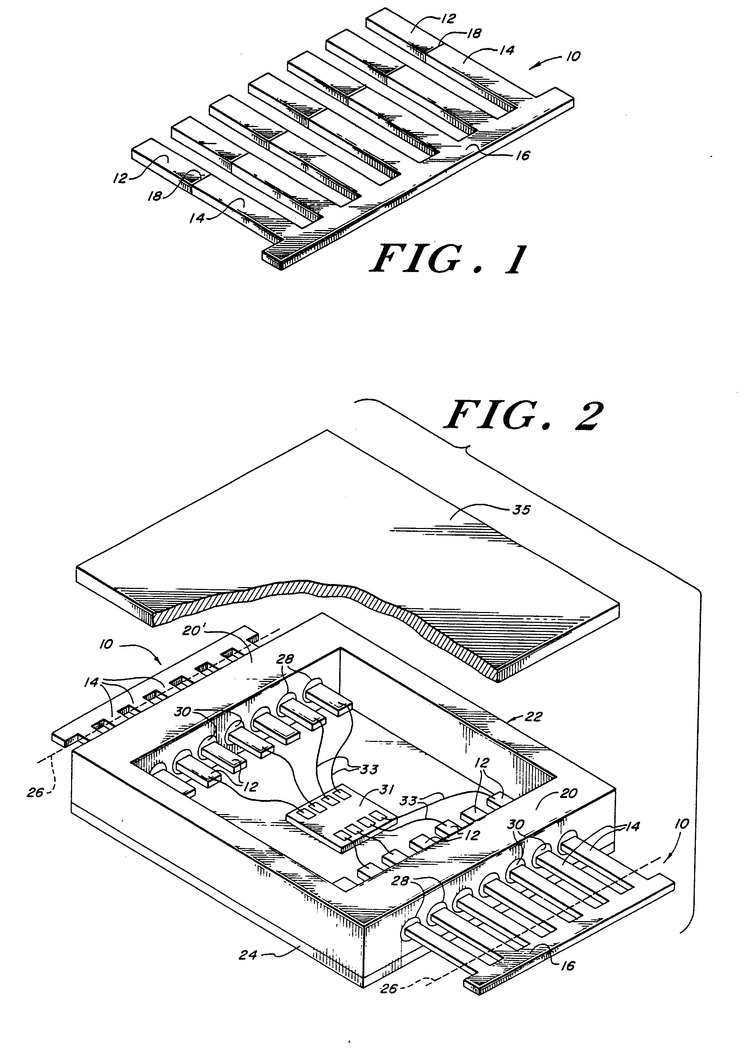

In order to establish a corrosion resistant electrical connection between the interior and the exterior of a flat pack, the lead frame for the pack, illustrated in Fig. 1 by reference character 10, is made in two parts in which an interior running portion 12 is electrically and mechanically connected to an exteriorly running portion 14 which is illustrated as having a carrier strip 16 at one end thereof. Portions 12 and 14, in one embodiment, are welded together along a seam line 18 prior to inserting the lead frame through the side wall of a flat pack and prior to the sealing thereof to the flat pack with feedthrough sealing material, such as glass.

In the preferred embodiment, the interior portion 12 is made of "Kovar", whereas the portion led to the exterior flat pack portion 14, is made of a corrosion resistant material such as nickel, stainless steel or aluminium. Additionally, this portion of the lead frame may be chosen for more acceptable thermal properties, such as increased thermal conductivity or a better thermal conductivity match with the frame of the flat pack or the material to which it is ultimately bonded.

"Kovar" is utilized for the interior portion of the lead frame because when utilizing borosilicate glass, its thermal expansion characteristic closely matches that of the glass and because it is easily bonded to the glass for an hermetic seal. After the lead frame has been secured to the microcircuit package, its surfaces may be coated with nickel and/or gold for the purposes described hereinbefore. Alternatively, selective coating may be applied to the lead frame prior to its insertion into the flat pack side wall apertures.

Referring to Fig. 2, in one embodiment, lead frame 10 is inserted through a side wall 20 of a ring 22 of a flat pack carrier, with the ring being secured and sealed to a base 24. As can be seen, the interior lead portions 12 extend into an interior cavity 26 defined by the ring, whereas the exterior portions 14 extend from the corresponding side wall 20 or 20'. The lead frames are sealed into individual apertures 28 by a borosilicate glass or other sealing material 30 such that when a microchip 31 is bonded to base 24 and is wire bonded by wires 31 or otherwise attached to interior leads, and a lid 35 is placed over the microchip carrier and sealed thereto by welding, soldering or brazing, then a hermetically sealed package results which is corrosion resistant and obviates the chipping, rusting, and discoloration problems associated with highly corrosive environments. It will be appreciated that lead frame 10 may be severed along dotted line 26 after fabrication, thereby to remove the carrier strip 16 for providing individual leads.

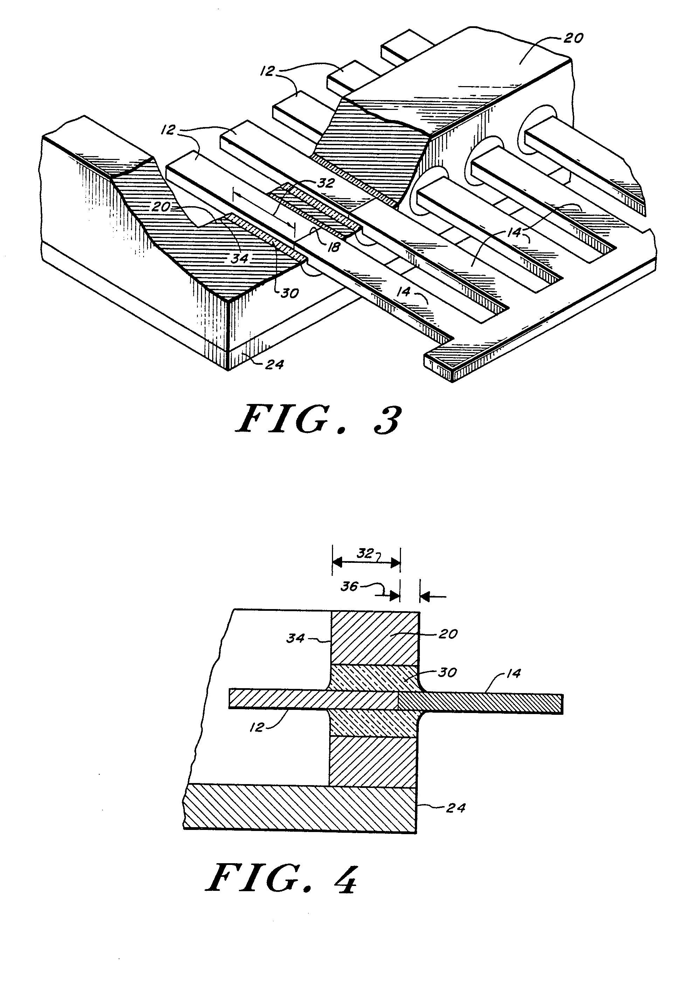

Referring to Figs. 3 and 4, it can be seen that interior portion 12 is sealed via sealing material 30 to side wall 20 along a length illustrated by arrow 32 which runs from the interior wall surface 34 to the weld or seamline 18 such that, as illustrated in Fig. 4, the sealing material 30 contacts the exterior lead portion 14 over a distance of, for instance 10 mils (.25 mm) as illustrated by arrow 36. In this case, the overall width of the side wall may be increased from 40 mils to 50 mils (1 mm to 1.25 mm) to provide a full 40 mils (1mm) for sealing to the interiorly running portion 12.

Any conventional method of providing feedthroughs may be utilized for the sealing of the multi-part lead frames to the microcircuit carrier. Other sealing materials include ceramics.

Having above indicated a preferred embodiment of the present invention, it will occur to those skilled in the art that modifications and alternatives can be practiced within the spirit of the invention. It is accordingly intended to define the scope of the invention only as indicated in the following claims.

## CLAIMS

What is claimed is :

1. A two-part lead frame (10) for use with a microcircuit package having at least one side wall (20) with apertures (28) therethrough, with said two-part lead frame being sealed in at least one of said apertures such that one lead frame portion (12) extends to the interior of said package and such that the other lead frame portion (14) extends exteriorly of said package, said lead frame portions being electrically and mechanically connected together.

2. The lead frame of claim 1, wherein said lead frame (10) is sealed in said aperture (28) by a sealant (30) having predetermined thermal characteristics and wherein said interiorly extending lead portion (12) has thermal characteristics which match those of said sealant material.

3. The lead frame of claim 2, wherein said interiorly projecting lead frame portion (12) is made of "Kovar".

4. The lead frame of claim 1, wherein the joint (18) between the two portions (12,14) lies close the exterior of said side wall (20).

5. The lead frame of claim 1, wherein said exteriorly extending lead frame portion (14) is a corrosion resistant material.

6. The lead frame of claim 1, wherein said exteriorly extending lead frame portion (14) is a material having preselected thermal characteristics.

7. The lead frame of claim 1, wherein said exteriorly extending lead frame portion (14) has preselected electrical characteristics.

8. A microcircuit package having a two-part bimetal lead frame (10) for achieving high integrity matched hermetic seals for withstanding corrosion comprising :

a microcircuit package having a side wall (20) with at least one aperture (28) therethrough, at least one two-part bimetal lead frame (10) extending through and being sealed to said aperture with a sealant (30), said two-part bimetal lead frame including an interiorly projecting portion (12) and an exteriorly projecting portion (14) which are electrically and mechanically connected together at a joint (18) , said joint being a predetermined short distance (36) away from the microcircuit package exterior.

9.　　　　　　The microcircuit package of claim 8, wherein said interior lead frame portion (12) is "Kovar".

10.　　　　　　The microcircuit package of claim 8, wherein at least a portion of said microcircuit is made of "Kovar", said portion including said apertured side wall (20).

11.　　　　　　The microcircuit package of claim 10, wherein said sealant (30) is a borosilicate glass.

12.　　　　　　The microcircuit package of claim 8, wherein said exterior lead frame portion (14) includes a material taken from the group consisting of nickel, stainless steel, or aluminum.

13.　　　　　　The microcircuit package of claim 8, wherein said interior lead frame portion (12) includes a material having thermal characteristics matched to that of said sealant (30).

14.　　　　　　The microcircuit package of claim 8, wherein said package includes a base (24), a ring (22) sealed to said base, and a lid (35) sealed to said ring, said microcircuit package including an electronic circuit (31) mounted to said base (24) and having electrical contact pads electrically connected to selected ones of said interior lead frame portions (12).

1/2                    0157685

*FIG. 1*

*FIG. 2*

**FIG. 3**

**FIG. 4**

## DOCUMENTS CONSIDERED TO BE RELEVANT

| Category | Citation of document with indication, where appropriate, of relevant passages | Relevant to claim | CLASSIFICATION OF THE APPLICATION (Int. Cl 4) |
|---|---|---|---|
| A | FR-A-2 436 498 (ISOTRONICS)<br><br>* Claim 1 * & US-A-42 66 090 (Cat. D)<br>--- | 1,8,10,11 | H 01 L 23/48<br>H 01 L 23/10 |
| A,P | PATENT ABSTRACTS OF JAPAN, vol. 8, no. 88, 21st April 1984, page (E-240)(1525); & JP - A - 59 - 6566 (HITACHI) 13-01-1984<br><br>----- | 1,8 | |

**TECHNICAL FIELDS SEARCHED (Int. Cl.4)**

H 01 L 23/06
H 01 L 23/10
H 01 L 23/48

The present search report has been drawn up for all claims

| Place of search | Date of completion of the search | Examiner |
|---|---|---|
| BERLIN | 14-06-1985 | GIBBS C.S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82